# EUROPÄISCHE PATENTSCHRIFT

(11) **EP 3 582 346 B1**
(45) Veröffentlichungstag und Bekanntmachung des Hinweises auf die Patenterteilung: **11.08.2021**
(21) Anmeldenummer: 18176919.1
(22) Anmeldetag: 11.06.2018
(51) Int. Cl.: H02B 1/30

(54) **SCHALTSCHRANK MIT SEITEWAND AUS LEITFÄHIGER TEXTILIE**
CONTROL CABINET WITH SIDE WALL FROM CONDUCTIVE TEXTILE
ARMOIRE DE DISTRIBUTION POURVUE DE PAROI LATÉRALE EN TEXTILE CONDUCTEUR

(43) Veröffentlichungstag der Anmeldung: 18.12.2019
(73) Patentinhaber: Rittal GmbH & Co. KG, 35745 Herborn (DE)
(72) Erfinder: Winsor, Derek, Mannamead, Plymouth Pl3 5AZ, Devon (GB)
(74) Vertreter: Angerhausen, Christoph

(56) Entgegenhaltungen:
- US-A1- 2014 008 119
- US-A1- 2018 027 706

## Beschreibung

Die Erfindung geht aus von einem Schaltschrank, der eine Mehrzahl vertikaler Rahmenprofile aufweist, durch die äußere Vertikalebenen festgelegt sind, wobei in mindestens einer der Vertikalebenen mindestens eine Seitenwand des Schaltschranks angeordnet ist, wobei die Seitenwand zumindest teilweise aus einer Textilie mit metallischen oder metallisch beschichteten Fäden oder Fasern besteht, wobei der Schaltschrank ein Dachelement aufweist, auf dessen Oberseite die Seitenwand über eine obere Halteklammer festgelegt ist, wobei eine EMI-Abschirmdichtung entlang einer Außenkante des Dachelements, vorzugsweise auf der Oberseite des Dachelements, zwischen Textilie und Dachelement angeordnet ist. Ein derartiger Schaltschrank ist beispielsweise aus der US 2018/0027706 A1 bekannt. Ein weiterer Schaltschrank mit textiler Seitenwand ist aus der US 2014/0008119 A1 bekannt. Ein Schaltschrank ist aus der DE 10 2015 121 193 B4 bekannt.

Die Seitenwände eines Schaltschranks sind üblicherweise als Flachteile aus gekantetem Metallblech ausgebildet. Dies hat in der Anreihsituation, bei der mehrere Schaltschränke aneinandergereiht eine Schaltschrankreihe bilden, den Nachteil, dass aufgrund der Materialstärke der Seitenwände die Anreihung erschwert wird. Bei Anwendungen, die eine Abschirmung elektromechanischer Strahlung verlangen, ist es andererseits jedoch auch nicht möglich, die aneinandergrenzenden Seitenwände der angereihten Schaltschränke wegzulassen.

Es ist daher die Aufgabe der Erfindung, einen Schaltschrank der eingangs beschriebenen Art derart weiterzuentwickeln, dass er bei einem geringen Aufbaumaß seiner Seitenwand gleichzeitig eine effektive elektromagnetische Abschirmung aufweist.

Diese Aufgabe wird durch einen Schaltschrank mit den Merkmalen des Anspruchs 1 gelöst. Der nebengeordnete Anspruch 12 betrifft ein entsprechendes Verfahren und der nebengeordnete Anspruch 13 eine entsprechende Schaltschrankreihe. Die abhängigen Ansprüche betreffen jeweils vorteilhafte Ausführungsformen der Erfindung.

Demgemäß ist vorgesehen, dass die EMI-Abschirmdichtung zwischen der Außenkante (11) des Dachelements (7) und der Halteklammer (8) angeordnet ist, wobei die Textilie (4) unter Kompression der EMI-Abschirmdichtung (10) durch Verlagerung der oberen Halteklammer (8) verspannt ist, wobei die Kompression der Dichtung (10) durch Variation der Verspannung variiert ist.

Es hat sich herausgestellt, dass derartige Textilien eine effektive Abschirmung gegenüber elektromagnetischer Strahlung bereits bei einer Materialstärke von weniger als 0,1 mm aufweisen. Beispielhaft sei ein metallisch beschichtetes Polyestergewebe erwähnt, dass bei einer Dicke von 0,1 mm und einem Flächengewicht von 80 g/m² eine Abschirmung von 80 bis 90 dB in einem Frequenzbereich zwischen 100 MHz und 18 GHz aufweist.

Die Fäden oder Fasern der Textilie können einen Polyesterkern mit einer metallischen Ummantelung aufweisen, insbesondere mit einer Ummantelung aus Kupfer und/oder Nickel. Bei einer Ausführungsform der Erfindung ist der Polyesterkern zunächst mit einer Nickelschicht beschichtet, die wiederum mit einer Kupferschicht beschichtet ist und die wiederum mit einer weiteren Nickelschicht beschichtet ist, so dass die Kupferschicht zwischen den beiden Nickelschichten eingebettet ist.

Bei dem Schaltschrank können zwei in gegenüberliegenden äußeren Vertikalebenen angeordnete und sich gegenüberliegende Seitenwände des Schaltschranks zumindest teilweise mit derselben Bahn der Textilie gebildet sein.

Es ist denkbar, dass sich die Textilie einteilig ausgehend von einer ersten der beiden äußeren Vertikalebenen erstreckt, von dort um 90° in die Horizontalebene übergeleitet und sich weiterhin über eine weitere 90°-Umlenkung einteilig bis in die gegenüberliegende äußere Vertikalebene erstreckt, so dass von derselben Textilie drei Außenseiten des Schaltschranks gebildet sind, nämlich die beiden gegenüberliegenden Seitenwände in den gegenüberliegenden äußeren Vertikalebenen und beispielsweise ein Dachelement des Schaltschranks, welches sich in der Horizontalebene befindet. Die Textilie kann insbesondere einteilig von einer ersten der äußeren Vertikalebenen über eine Horizontalebene des Schaltschranks in eine zweite, der ersten gegenüberliegende äußere Vertikalebene fortgeführt sein.

Die obere Halteklammer kann an dem Dachelement verschraubt und die Seitenwand zwischen der Oberseite des Dachelements und der Halteklammer eingeklemmt sein. Anstelle einer Verschraubung kann jedes andere Befestigungsmittel vorgesehen sein, welches geeignet ist, die Halteklammer in Bezug auf das Dachelement des Schaltschranks zu arretieren und die

Textilie zwischen den beiden festzulegen. Das Dachelement kann beispielsweise als ein Flachteil ausgebildet sein, wie es grundsätzlich aus dem Stand der Technik bekannt ist. Es kann auch vorgesehen sein, dass eine Schraubverbindung durch die Halteklammer und die Textilie hindurch bis in das Dachelement hineingeführt ist.

Die obere Halteklammer kann einen L-förmigen Steg mit einem von dem Dachelement abstehenden freien Ende aufweisen. Das abstehende freie Ende kann ein Betätigungsende sein, welches es bei der Montage der Textilie in der Vertikalebene erlaubt, die Textilie gegebenenfalls an den Rahmenprofilen des Schaltschranks, insbesondere am Rahmengestell des Schaltschranks, aufzuspannen. Ein geeignetes Rahmengestell ist beispielsweise aus der DE 10 2015 121 193 B4 bekannt, bei dem eine umlaufende äußere Dichtkante des Rahmengestells in der Vertikalebene angeordnet ist, über welche sich die Textilie optimal aufspannen lässt.

Der Schaltschrank kann weiterhin eine Bodenbaugruppe aufweisen und die Seitenwand an der Unterseite der Bodenbaugruppe über eine untere Halteklammer festgelegt sein. Die untere Halteklammer kann an der Bodenbaugruppe verschraubt sein. Analog zu der oberen Halteklammer sind jedoch auch andere Befestigungsmittel geeignet, um die Halteklammer an der Bodenbaugruppe festzulegen, so lange sie eine Arretierung der Halteklammer in Bezug auf die Bodenbaugruppe erlauben, was erforderlich ist, um die die Seitenwand bildende Textilie in der Vertikalebene anzuordnen und gegebenenfalls aufzuspannen.

Die untere Halteklammer kann eine am Innenumfang der Bodenbaugruppe abstehende untere Kante der Bodenbaugruppe umgreifen. Dazu kann die untere Halteklammer eine U-Umkantung aufweisen, mit der die untere Halteklammer die am Innenumfang der Bodenbaugruppe abstehende untere Kante umgreift.

Die untere Halteklammer kann einen L-förmigen Steg mit einem von der Bodenbaugruppe abstehenden freien Ende aufweisen, welches der manuellen Betätigung der Haltklammer dient, insbesondere zum Vorspannen des Textils in der Vertikalebene.

Eine weitere EMI-Abschirmdichtung kann entlang einer Außenkante der Bodenbaugruppe, vorzugsweise auf der Unterseite der Bodenbaugruppe, zwischen Textilie und Bodenbaugruppe angeordnet sein und die Textilie unter Kompression der EMI-Abschirmdichtung vorspannen.

Gemäß einem anderen Aspekt der Erfindung wird ein Verfahren zur Montage einer Seitenwand an einem Schaltschrank der zuvor beschriebenen Art beschrieben, wobei der Schaltschrank insbesondere ein Dachelement und eine Bodenbaugruppe aufweist, die über vertikale Rahmenprofile miteinander verbunden sind. Dabei weist das Verfahren die Schritte auf:
- Anordnen einer ersten EMI-Abschirmdichtung entlang einer einer zu montierenden Seitenwand zugeordneten oberen Außenkante des Dachelements;
- Anordnen einer zweiten EMI-Abschirmdichtung entlang einer der zu montierenden Seitenwand zugeordneten unteren Außenkante des Bodenrahmens;
- Befestigen einer oberen Halteklammer an dem Dachelement und Einklemmen der Textilie entlang einer ersten Kante der Textilie zwischen oberer Halteklammer und dem Dachelement;
- Befestigen einer unteren Halteklammer an der Bodenbaugruppe und Einklemmen der Textilie entlang einer der ersten Kante gegenüberliegenden zweiten Kante der Textilie zwischen unteren Halteklammer und der Bodenbaugruppe;
- Straffen der Textilie durch Arretieren einer der beiden Halteklammern, danach Verlagern der anderen Halteklammer und danach Arretieren auch der anderen Halteklammer.

Für das Straffen der Textilie kann die Textilie an der verlagerten Halteklammer festgelegt werden.

Gemäß noch einem anderen Aspekt der Erfindung wird eine Schaltschrankreihe aus mindestens zwei aneinander grenzenden Schaltschränken der zuvor beschriebenen Art beschrieben, wobei mindestens eine sich zwischen den Schaltschränken befindende Seitenwand zumindest teilweise aus einer Textilie mit metallisch beschichteten Fäden oder Fasern besteht.

Weitere Einzelheiten der Erfindung werden anhand der nachstehenden Figuren erläutert. Dabei zeigt:
- Figur 1: einen Schaltschrank gemäß dem Stand der Technik in perspektivischer Darstellung;
- Figur 2: einen erfindungsgemäßen Schaltschrank gemäß einer Ausführungsform der Erfindung in perspektivischer Detailansicht im Bereich einer oberen Ecke des Schaltschranks;
- Figur 3: eine weitere Ausführungsform eines erfindungsgemäßen Schaltschranks im Bereich des Dachelements und im Querschnitt senkrecht zur Vertikalebene und zur Horizontalebene;
- Figur 4: die Ausführungsform gemäß Figur 3 im Bereich der Bodenbaugruppe und im Querschnitt senkrecht zur Vertikalebene und Horizontalebene; und
- Figur 5: eine beispielhafte Textilie.

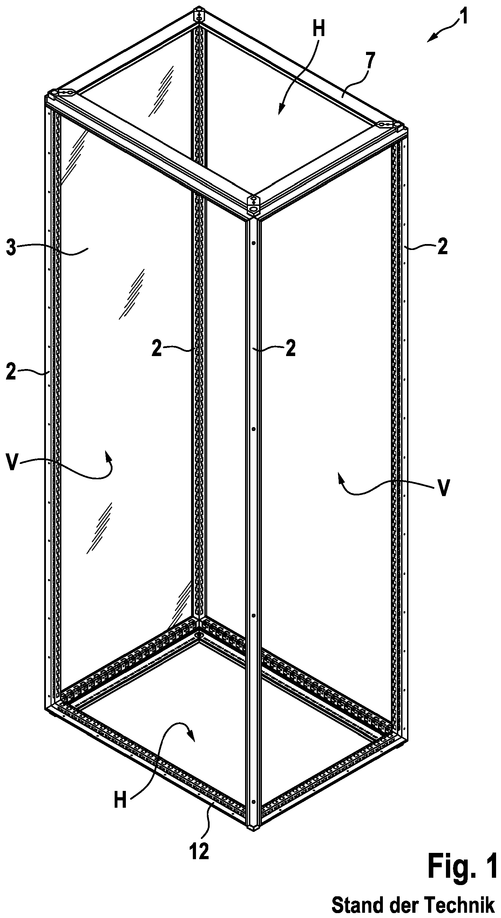

Die Figur 1 zeigt einen Schaltschrank 1 gemäß dem Stand der Technik. Ein derartiger Schaltschrank ist beispielsweise in der DE 10 2015 121 193 B4 beschrieben. Der Schaltschrank 1 weist ein Rahmengestell auf, welches aus vier vertikalen Rahmenprofilen 2, einem Dachelement 7 und einer Bodenbaugruppe 12 aufgebaut ist. Das Dachelement 7 und die Bodenbaugruppe 12 sind im Wesentlichen rechteckig ausgebildet und in ihren Ecken, über jeweils eines der vertikalen Rahmenprofile 2 parallel voneinander beabstandet miteinander verbunden. Eine Seitenwand 3 des Schaltschranks 1 ist als ein Flachteil ausgebildet, welches beispielsweise ein gekantetes Blechformteil sein kann.

Die Seitenwand 3 ist in der Vertikalebene V an zwei vertikalen Rahmenprofilen 2 sowie der Bodenbaugruppe 12 und dem Dachelement 7 festgelegt. Wenn die Seitenwand 3 des Schaltschranks 1 als Blechformteil ausgebildet ist, weist sie zwar eine hervorragende EMV-Abschirmung auf. Andererseits weist sie mit einer Materialstärke von beispielsweise 1,5 mm jedoch eine erhebliche Aufbauhöhe auf, welche die Anreihung identischer der in Figur 1 gezeigten Schaltschränke erschwert.

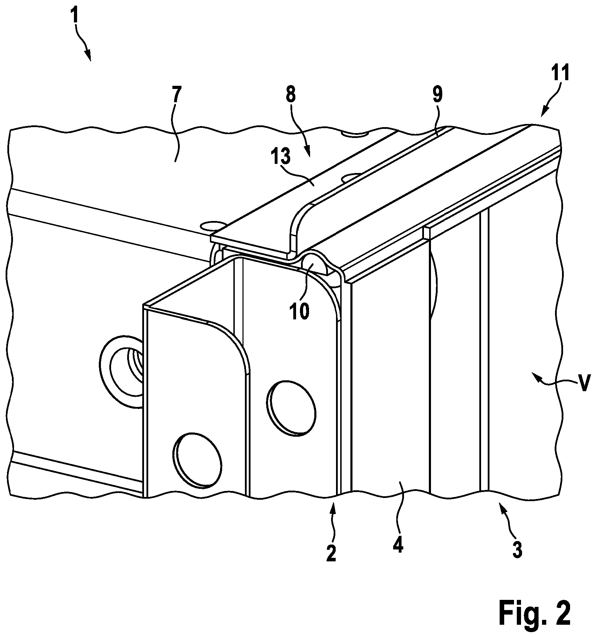

Diese Problematik kann durch die in Figur 2 gezeigte beispielhafte Ausführungsform eines erfindungsgemäßen Schaltschranks 1 gelöst werden. Demgemäß ist vorgesehen, dass in mindestens einer der Vertikalebenen V des Schaltschranks 1 eine Seitenwand 3 angeordnet ist, die zumindest teilweise aus einer Textilie 4 mit metallisch beschichteten Fäden oder Fasern besteht. Vorzugsweise ist die Seitenwand 3 in wesentlichen Teilen aus einer derartigen Textilie 4 ausgebildet. Insbesondere kann vorgesehen sein, dass die Seitenwand 3, zumindest insoweit wie sie in der Vertikalebene V angeordnet ist, aus einer solchen Textilie bestehen, so dass sie allenfalls noch im Randbereich, zur Bereitstellung von Befestigungsmitteln aus einem anderen Material bestehen kann. Wie in Figur 2 gezeigt ist, ist es jedoch möglich, die Seitenwand 3 vollständig aus der zuvor beschriebenen Textilie herzustellen.

Dies wird dadurch erreicht, dass die in der Vertikalebene V angeordnete Textilie 4 in einem oberen Randbereich um eine Außenkante 11, entlang welcher das Dachelement 7 in die Seitenwand 3 übergeht, auf eine Oberseite des Dachelements 7 weitergeführt ist, um dort mit Hilfe einer oberen Halteklammer 8 an der Oberseite des Dachelements 7 verklemmt zu werden. Um eine effektive Abdichtung im Hinblick auf elektromagnetische Strahlung zu erreichen, ist auf der Oberseite des Dachelements 7 eine EMI-Abschirmdichtung 10 ausgebildet, die zwischen der Textilie 4 und der Oberseite des Dachelements 7 angeordnet ist, so dass die Textilie 4 die EMI-Abschirmdichtung 10 überspannt und dabei dichtend an der EMI-Abschirmdichtung 10 anliegt.

Die obere Halteklammer 8 weist einen L-förmigen Steg 13 mit einem freien Ende 9 auf, mit Hilfe welches die Halteklammer 8 parallel zu der Oberseite des Dachelements 7 verlagert werden kann, um die Textilie 4 zu spannen. Die EMI-Abschirmdichtung ist dabei zwischen der Außenkante 11 des Dachelements 7 und der Halteklammer 8 auf der Oberseite des Dachelements 7 angeordnet, so dass mit dem Verspannen der Textilie 4 auch der Anpressdruck der Textilie 4 auf der EMI-Abschirmdichtung 10 variiert und damit die Kompression der Dichtung 10 sowie infolgedessen die Dichtwirkung variiert werden kann. Die Abdichtung der Textilie 4 gegenüber dem Dachelement 7 wird noch dadurch weiter begünstigt, dass die Textilie, welche beispielsweise ein Gewebe sein kann, eine natürliche Eigenelastizität aufweisen kann, so dass ein wirkungsvolles Aufspannen der Textilie 4 über die Kante 11 und das Dichtelement 10 durch Verlagern der oberen Halteklammer 8 möglich ist.

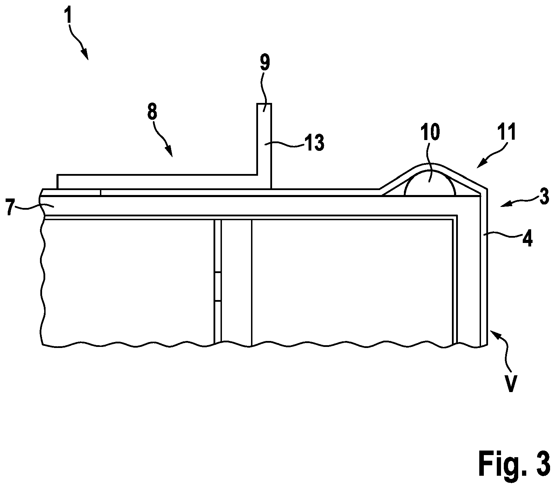

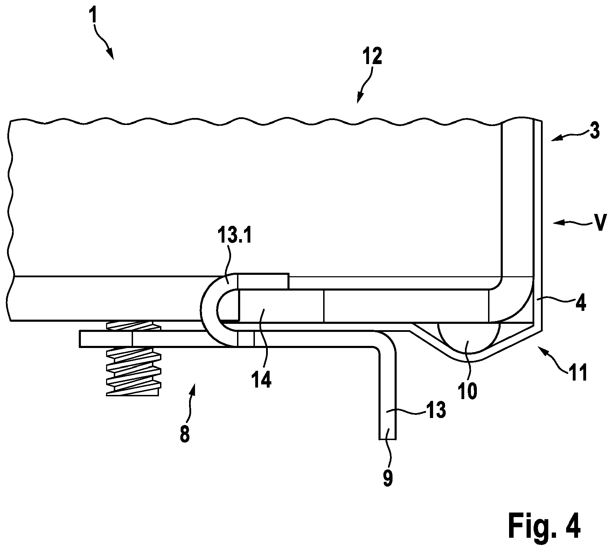

Weitere Einzelheiten zu der Befestigung der Textilie 4 am Dachelement 7 beziehungsweise an der Bodenbaugruppe 12 werden mit Bezug auf die Ausführungsform gemäß den Figuren 3 und 4 erläutert.

Wie in den Figuren 3 und 4 gezeigt ist, kann sich die in der Vertikalebene V zwischen dem Dachelement 7 und der Bodenbaugruppe 12 erstreckende Textilie 4, welche die Seitenwand 3 bildet, einteilig an einer Unterseite der Bodenbaugruppe 12 über die gesamte Länge der Vertikalebene V bis auf die Oberseite des Dachelements 7 erstrecken. Die einteilige Textilie 4 kann entlang einer ersten von zwei gegenüberliegenden Kanten 11 mit Hilfe einer oberen Halteklammer 8 an der Oberseite des Dachelements 7 und an einer der ersten Kante 11 gegenüberliegenden zweiten Kante 11 mit einer unteren Halteklammer 8 an der Unterseite der Bodenbaugruppe 12 festgelegt werden. Die obere Halteklammer 8 kann beispielsweise über eine Schraubverbindung mit dem Dachelement 7 durch die Textilie 4 hindurch verschraubt sein. Um ein Verspannen der Textilie 4 zu ermöglichen, kann die obere Halteklammer 8 unter einem variablen Abstand zur Vertikalebene auf der Oberseite des Dachelements 7 befestigt werden. Dazu kann die obere Halteklammer 8 beispielsweise ein Langloch aufweisen, welches sich parallel zu dem Dachelement 7 und senkrecht zu der Vertikalebene V erstreckt.

Die untere Halteklammer 8 gemäß Figur 4 kann dazu eingerichtet sein, um in genau einer bestimmten Position mit der Bodenbaugruppe 12 fest verbunden zu werden, wobei eine untere Kante der Textilie 4 zwischen der unteren Halteklammer 8 und der Unterseite der Bodenbaugruppe 12 eingeklemmt ist. Anders als die obere Halteklammer 8 gemäß Figur 3 kann vorgesehen sein, dass die untere Halteklammer 8 gemäß Figur 4 nicht in Richtung senkrecht zu der Vertikalebene V verlagerbar ist. Die untere Halteklammer 8 unterscheidet sich insbesondere dadurch von der oberen Halteklammer 8, dass sie eine U-Umkantung 13.1 aufweist, mit welcher sie eine am Innenumfang der Bodenbaugruppe 12 abstehende untere Kante 14 der Bodenbaugruppe 12 umgreift.

In der Zusammenschau der Figuren 3 und 4 ist zu erkennen, dass die die Seitenwand 3 in der Vertikalebene V bildende Textilie 4 einteilig zwischen der Unterseite der Bodenbaugruppe 12 und der Oberseite des Dachelements 7 geführt ist, jeweils um eine Außenkante 11 der Bodenbaugruppe 12 beziehungsweise des Dachelements 7 herum, wobei der jeweiligen Außenkante 11 beigeordnet eine EMI-Abschirmdichtung 10 an der Unterseite der Bodenbaugruppe 12 und an der Oberseite des Dachelements 7 angeordnet ist. Die Textilie 4 ist aus der Vertikalebene V um die Außenkanten 11 herum und über die EMI-Abschirmdichtungen 10 aufgespannt und mit ihren gegenüberliegenden Kanten an der Unterseite der Bodenbaugruppe 12 beziehungsweise an der Oberseite des Dachelements 7 eingeklemmt.

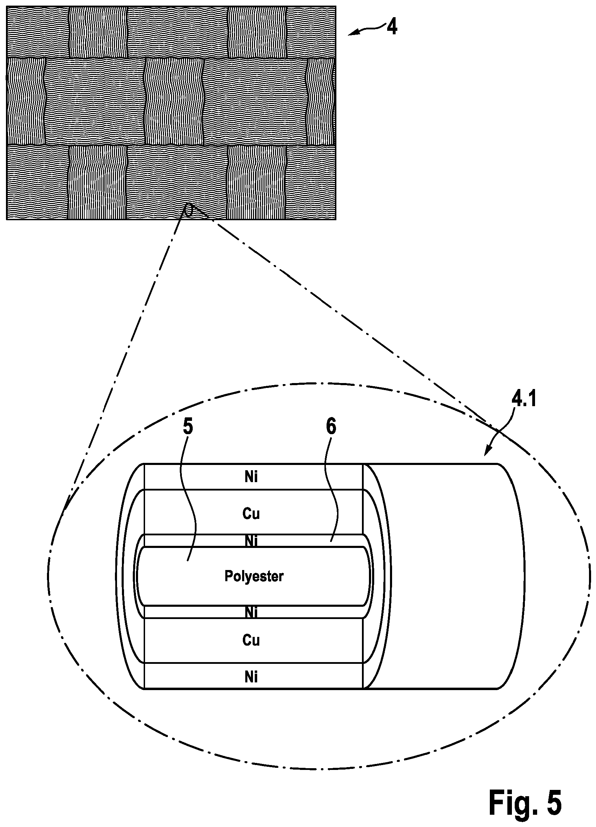

Die Figur 5 zeigt ein beispielhaftes Textil 4 sowie in vergrößerter Darstellung schematisch einen Anschnitt eines Fadens bzw. einer Faser 4.1, aus denen die Textilie gebildet ist. Die in Figur 5 gezeigte Textilie 4 kann nach Art eines Gewebes ausgebildet sein. Der Faden 4.1 des Gewebes weist einen Polyesterkern 5 auf, der von einer metallischen Schicht ummantelt ist. Die metallische Schicht weist zwei Schichten Nickel und eine Schicht Kupfer auf. Dabei ist der Polyesterkern von einer ersten Nickelschicht ummantelt. Die Kupferschicht ist zwischen der ersten Nickelschicht und einer zweiten, äußeren Nickelschicht eingebettet.

### Bezugszeichenliste:

- 1: Schaltschrank
- 2: Vertikales Rahmenprofil
- 3: Seitenwand
- 4: Textil
- 4.1: Faden/Faser
- 5: Polyesterkern
- 6: Metallische Ummantelung
- 7: Dachelement
- 8: Halteklammer
- 9: Ende
- 10: EMI-Abschirmdichtung
- 11: Außenkante
- 12: Bodenbaugruppe
- 13: L-förmiger Steg
- 13.1: U-Umkantung
- 14: Kante
- H: Horizontalebene
- V: Vertikalebene

## Patentansprüche

1. Schaltschrank (1), der eine Mehrzahl vertikaler Rahmenprofile (2) aufweist, durch die äußere Vertikalebenen (V) festgelegt sind, wobei in mindestens einer der Vertikalebenen (V) mindestens eine Seitenwand (3) des Schaltschranks (1) angeordnet ist, wobei die Seitenwand (3) zumindest teilweise aus einer Textilie (4) mit metallischen oder metallisch beschichteten Fäden oder Fasern (4.1) besteht, wobei der Schaltschrank (1) ein Dachelement (7) aufweist, auf dessen Oberseite die Seitenwand (3) über eine obere Halteklammer (8) festgelegt ist, wobei eine EMI-Abschirmdichtung (10) entlang einer Außenkante (11) des Dachelements (7), auf der Oberseite des Dachelements (7), zwischen Textilie (4) und Dachelement (7) angeordnet ist, **dadurch gekennzeichnet, dass** die EMI-Abschirmdichtung zwischen der Außenkante (11) des Dachelements (7) und der Halteklammer (8) angeordnet ist, wobei die Textilie (4) unter Kompression der EMI-Abschirmdichtung (10) durch Verlagerung der oberen Halteklammer (8) verspannt ist, wobei die Kompression der Dichtung (10) durch Variation der Verspannung variiert ist.

2. Schaltschrank (1) nach Anspruch 1, bei dem die Fäden oder Fasern (4.1) der Textilie (4) einen Polyesterkern (5) mit einer metallischen Ummantelung (6), insbesondere einer Kupfer-Nickel-Ummantelung (6), aufweisen.

3. Schaltschrank (1) nach einem der vorangegangenen Ansprüche, bei dem zwei in gegenüberliegenden äußeren Vertikalebenen (V) angeordnete und sich gegenüberliegende Seitenwände (3) des Schaltschranks (1) zumindest teilweise mit derselben Bahn der Textilie (4) gebildet sind.

4. Schaltschrank (1) nach einem der vorangegangenen Ansprüche, bei dem die Textilie (4) einteilig von einer ersten der äußeren Vertikalebenen (V) über eine Horizontalebene (H) des Schaltschranks (1) in eine zweite, der ersten gegenüber liegende der äußeren Vertikalebenen (V) fortgeführt ist.

5. Schaltschrank (1) nach einem der vorangegangenen Ansprüche, bei dem die obere Halteklammer (8) an dem Dachelement (7) verschraubt und die Seitenwand (3) zwischen der Oberseite des Dachelements (7) und der Halteklammer (8) eingeklemmt ist.

6. Schaltschrank (1) nach einem der vorangegangenen Ansprüche, bei dem die obere Halteklammer (8) einen L-förmigen Steg (13) mit einem von dem Dachelement (7) abstehenden freien Ende (9) aufweist.

7. Schaltschrank (1) nach einem der vorangegangenen Ansprüche, der eine Bodenbaugruppe (12) aufweist und die Seitenwand (3) an der Unterseite der Bodenbaugruppe (12) über eine untere Halteklammer (8) festgelegt ist.

8. Schaltschrank (1) nach Anspruch 7, wobei die untere Halteklammer (8) an der Bodenbaugruppe (12) verschraubt ist.

9. Schaltschrank (1) nach einem der vorangegangenen Ansprüche, wobei die untere Halteklammer (8) eine am Innenumfang der Bodenbaugruppe (12) abstehende untere Kante (14) der Bodenbaugruppe (12) umgreift.

10. Schaltschrank (1) nach einem der vorangegangenen Ansprüche, bei dem die untere Halteklammer (8) einen L-förmigen Steg (13) mit einem von der Bodenbaugruppe (12) abstehenden freien Ende (9) aufweist.

11. Schaltschrank (1) nach einem der vorangegangenen Ansprüche, bei dem eine weitere EMI-Abschirmdichtung (10) entlang einer Außenkante (11) der Bodenbaugruppe (12), vorzugsweise auf der Unterseite der Bodenbaugruppe, (12) zwischen Textilie (4) und Bodenbaugruppe (12) angeordnet und die Textilie (4) unter Kompression der EMI-Abschirmdichtung (10) vorspannt ist.

12. Verfahren zur Montage einer Seitenwand (3) an einem Schaltschrank (1) nach einem der vorangegangen Ansprüche, wobei der Schaltschrank (1) ein Dachelement (7) und eine Bodenbaugruppe (12) aufweist, die über vertikale Rahmenprofile (2) miteinander verbunden sind, und wobei das Verfahren die Schritte aufweist:
- Anordnen einer ersten EMI-Abschirmdichtung (10) entlang einer einer zu montierenden Seitenwand (3) zugeordneten oberen Außenkante (11) des Dachelements (7);
- Anordnen einer zweiten EMI-Abschirmdichtung (10) entlang einer der zu montierenden Seitenwand (3) zugeordneten unteren Außenkante (11) des Bodenrahmens;
- Befestigen einer oberen Halteklammer (8) an dem Dachelement (7) und Einklemmen der Textilie (4) entlang einer ersten Kante der Textilie (4) zwischen oberer Halteklammer (8) und dem Dachelement (7)
- Befestigen einer unteren Halteklammer (8) an der Bodenbaugruppe (12) und Einklemmen der Textilie (4) entlang einer der ersten Kante gegenüber liegenden zweiten Kante der Textilie (4) zwischen unteren Halteklammer (8) und der Bodenbaugruppe (12);
- Straffen der Textilie (4) durch Arretieren einer der beiden Halteklammern (8), danach Verlagern der anderen Halteklammer (8) und danach Arretieren auch der anderen Halteklammer (8).

13. Schaltschrankreihe aus mindestens zwei aneinander grenzenden Schaltschränken (1) nach einem der Ansprüche 1 bis 11, **dadurch gekennzeichnet, dass** mindestens eine sich zwischen den Schaltschränken (1) befindende Seitenwand (3) zumindest teilweise aus einer Textilie (4) mit metallischen oder metallisch beschichteten Fäden oder Fasern besteht.

## Claims

1. A switch cabinet (1) which has a plurality of vertical frame profiles (2) by which outer vertical planes (V) are defined, at least one sidewall (3) of the switch cabinet (1) being arranged in at least one of the vertical planes (V), the sidewall (3) consisting at least partially of a textile (4) with metallic or metallically coated threads or fibres (4.1), the switch cabinet (1) having a roof element (7), on the upper side of which the sidewall (3) is fixed via an upper retaining clip (8), an EMI shielding seal (10) being arranged along an outer edge (11) of the roof element (7), on the upper side of the roof element (7), between the textile (4) and the roof element (7), **characterised in that** the EMI shielding seal (10) is arranged between the outer edge (11) of the roof element (7) and the retaining clip (8), the textile (4) being braced under compression of the EMI shielding seal (10) by displacement of the upper retaining clip (8), the compression of the seal (10) being varied by variation of the bracing.

2. The switch cabinet (1) according to claim 1, wherein the threads or fibres (4.1) of the textile (4) comprise a polyester core (5) with a metallic sheath (6), in particular a copper-nickel sheath (6).

3. The switch cabinet (1) according to one of the preceding claims, in which two sidewalls (3) of the switch cabinet (1), arranged in opposite outer vertical planes (V) and facing each other, are formed at least partially with the same web of textile (4).

4. The switch cabinet (1) according to one of the preceding claims, in which the textile (4) is continued in one piece from a first of the outer vertical planes (V) over a horizontal plane (H) of the switch cabinet (1) into a second of the outer vertical planes (V) opposite the first.

5. The switch cabinet (1) according to one of the preceding claims, wherein the upper retaining clip (8) is screwed to the roof element (7) and the sidewall (3) is clamped between the upper side of the roof element (7) and the retaining clip (8).

6. The switch cabinet (1) according to any of the preceding claims, wherein the upper retaining clip (8) has an L-shaped web (13) with a free end (9) projecting from the roof element (7).

7. The switch cabinet (1) according to any one of the preceding claims, which comprises a bottom assembly (12) and the sidewall (3) is fixed to the underside of the bottom assembly (12) via a lower retaining clip (8).

8. The Switch cabinet (1) according to claim 7, wherein the lower retaining bracket (8) is screwed to the bottom assembly (12).

9. The switch cabinet (1) according to any one of the preceding claims, wherein the lower retaining clip (8) embraces a lower edge (14) of the bottom assembly (12) projecting from the inner circumference of the bottom assembly (12).

10. The switch cabinet (1) according to any one of the preceding claims, wherein the lower retaining clip (8) has an L-shaped web (13) with a free end (9) projecting from the bottom assembly (12).

11. The switch cabinet (1) according to any one of the preceding claims, wherein a further EMI shielding seal (10) is arranged along an outer edge (11) of the bottom assembly (12), preferably on the underside of the bottom assembly, (12) between the textile (4) and the bottom assembly (12) and the textile (4) is biased under compression of the EMI shielding seal (10).

12. A method of mounting a sidewall (3) to an enclosure (1) according to any one of the preceding claims, wherein the enclosure (1) comprises a roof element (7) and a bottom assembly (12) interconnected by vertical frame profiles (2), the method comprising the steps of:
- arranging a first EMI shielding seal (10) along an upper outer edge (11) of the roof element (7) associated with a sidewall (3) to be mounted;
- arranging a second EMI shielding seal (10) along a lower outer edge (11) of the floor frame associated with the sidewall (3) to be mounted;
- attaching an upper retaining clip (8) to the roof element (7) and clamping the textile (4) along a first edge of the textile (4) between the upper retaining clip (8) and the roof element (7); and
- attaching a lower retaining clip (8) to the floor assembly (12) and clamping the textile (4) along a second edge of the textile (4) opposite the first edge between the lower retaining clip (8) and the floor assembly (12);
- tightening the textile (4) by locking one of the two retaining clips (8), then displacing the other retaining clip (8) and then also locking the other retaining clip (8).

13. A row of switch cabinets consisting of at least two adjacent switch cabinets (1) according to one of claims 1 to 11, **characterised in that** at least one sidewall (3) located between the switch cabinets (1) consists at least partially of a textile (4) with metallic or metallically coated threads or fibres.

## Revendications

1. Armoire de commande (1) qui comprend une pluralité de profilés de cadres verticaux (2), grâce auxquels des plans verticaux (V) sont définis, dans laquelle, dans au moins un des plans verticaux (V), est disposée au moins une paroi latérale (3) de l'armoire de commande (1), dans laquelle la paroi latérale (3) est constituée au moins partiellement d'un textile (4) avec des fils ou des fibres métalliques ou revêtues d'un métal (4.1), dans laquelle l'armoire de commande (1) comprend un élément de toit (7) sur le côté supérieur duquel la paroi latérale (3) est fixée par l'intermédiaire d'une agrafe de maintien supérieure (8), dans laquelle un joint d'étanchéité à blindage EMI (10) est disposé le long d'une arête externe (11) de l'élément de toit (7), sur le côté supérieur de l'élément de toit (7), entre le textile (4) et l'élément de toit (7), **caractérisée en ce que** le joint d'étanchéité à blindage EMI est disposé entre l'arête externe (11) de l'élément de toit (7) et l'agrafe de maintien (8), dans laquelle le textile (4) est tendu sous l'effet d'une compression du joint d'étanchéité à blindage EMI (10) par le déplacement de l'agrafe de maintien supérieure (8), dans laquelle la compression du joint d'étanchéité (10) est modifiée par la variation de la tension.

2. Armoire de commande (1) selon la revendication 1, dans laquelle les fils ou fibres (4.1) du textile (4) comprennent un noyau en polyester (5) avec une enveloppe métallique (6), plus particulièrement une enveloppe cuivre-nickel (6).

3. Armoire de commande (1) selon l'une des revendications précédentes, dans laquelle deux parois latérales (3), opposées et disposées dans des plans verticaux externes (V) opposés, de l'armoire de commande (1) sont constituées au moins partiellement de la même bande de textile (4).

4. Armoire de commande (1) selon l'une des revendications précédentes, dans laquelle le textile (4) est constitué d'une seule pièce d'un premier des plans verticaux externes (V) en passant par un plan horizontal (H) de l'armoire de commande (1) vers un deuxième plan vertical externe (V), opposé aux premiers plans verticaux externes (V).

5. Armoire de commande (1) selon l'une des revendications précédentes, dans laquelle l'agrafe de maintien supérieure (8) est vissée à l'élément de toit (7) et la paroi latérale (3) est serrée entre le côté supérieur de l'élément de toit (7) et l'agrafe de maintien (8).

6. Armoire de commande (1) selon l'une des revendications précédentes, dans laquelle l'agrafe de maintien supérieure (8) comprend une nervure en forme de L (13) avec une extrémité libre (9) s'écartant de l'élément de toit (7).

7. Armoire de commande (1) selon l'une des revendications précédentes, qui comprend un sous-ensemble de fond (12) et la paroi latérale (3) est fixé au côté inférieur du sous-ensemble de fond (12) par l'intermédiaire d'une agrafe de maintien inférieure (8).

8. Armoire de commande (1) selon la revendication 7, dans laquelle l'agrafe de maintien inférieure (8) est vissée au sous-ensemble de fond (12).

9. Armoire de commande (1) selon l'une des revendications précédentes, dans laquelle l'agrafe de maintien inférieure (8) entoure une arête inférieure (14) du sous-ensemble de fond (12) s'écartant de la circonférence interne du sous-ensemble de fond (12).

10. Armoire de commande (1) selon l'une des revendications précédentes, dans laquelle l'agrafe de maintien inférieure (8) comprend une nervure en forme de L (13) avec une extrémité libre (9) s'écartant du sous-ensemble de fond (12).

11. Armoire de commande (1) selon l'une des revendications précédentes, dans laquelle un autre joint d'étanchéité à blindage EMI (10) est disposé le long d'une arête externe (11) du sous-ensemble de fond (12), de préférence sur le côté inférieur du sous-ensemble de fond (12), entre le textile (4) et le sous-ensemble de fond (12), et le textile (4) est précontraint sous l'effet de la compression du joint d'étanchéité à blindage EMI (10).

12. Procédé de montage d'une paroi latérale (3) sur une armoire de commande (1) selon l'une des revendications précédentes, dans lequel l'armoire de commande (1) comprend un élément de toit (7) et un sous-ensemble de fond (12) qui sont reliés entre eux par l'intermédiaire de profilés de cadres verticaux (2) et dans lequel le procédé comprend les étapes suivantes :
- disposition d'un premier joint d'étanchéité à blindage EMI (10) le long d'une arête externe supérieure (11) de l'élément de toit (7) correspondant à une paroi latérale (3) à monter ;
- disposition d'un deuxième joint d'étanchéité à blindage EMI (10) le long d'une arête externe inférieure (11) du cadre de fond correspondant à la paroi latérale (3) à monter ;
- fixation d'une agrafe de maintien supérieure (8) à l'élément de toit (7) et serrage du textile (4) le long d'une première arête du textile (4) entre l'agrafe de maintien supérieure (8) et l'élément de toit (7) ;
- fixation d'une agrafe de maintien inférieure (8) au sous-ensemble de fond (12) et serrage du textile (4) le long d'une deuxième arête du textile (4), opposée à la première arête, entre l'agrafe de maintien inférieure (8) et le sous-ensemble de fond (12) ;
- tension du textile (4) par blocage d'une des deux agrafes de maintien (8) puis déplacement de l'autre agrafe de maintien (8) et par blocage également de l'autre agrafe de maintien (8).

13. Série d'armoires de commande constituée d'au moins deux armoires de commande (1) adjacentes selon l'une des revendications 1 à 11, **caractérisée en ce qu'**au moins une paroi latérale (3) se trouvant entre les armoires de commande (1) est constituée au moins partiellement d'un textile (4) avec des fils ou fibres métalliques ou revêtues de métal.
